# EUROPEAN PATENT SPECIFICATION

(11) **EP 4 232 830 B1**
(45) Date of publication and mention of the grant of the patent: **23.10.2024**
(21) Application number: 21785997.4
(22) Date of filing: 17.09.2021
(51) Int. Cl.: G01R 19/165, H01R 13/66, H01R 13/70, H01R 31/06

(54) **CURRENT MEASUREMENT DEVICE FOR MOBILE RECHARGEABLE DEVICES**
STROMMESSVORRICHTUNG FÜR MOBILE WIEDERAUFLADBARE GERÄTE
DISPOSITIF DE MESURE DE COURANT POUR DISPOSITIFS RECHARGEABLES MOBILES

(30) Priority: 22.09.2020 IT 202000022249
(43) Date of publication of application: 30.08.2023
(73) Proprietor: Witty S.r.l.s., 00136 Roma (IT)
(72) Inventor: MARTINI, Luca, 00168 Roma (IT); CRAIA, Lorenzo, 00168 Roma (IT); TOGNOLI, Andrea, 00168 Roma (IT)
(74) Representative: Pace Napoleone, Maria
(86) International application number: PCT/IB2021/058486
(87) International publication number: WO 2022/064334

(56) References cited:
- US-A1- 2009 294 150
- US-A1- 2013 200 841
- US-A1- 2018 032 044
- US-A1- 2018 269 701
- US-A1- 2019 140 464

## Description

### TECHNICAL FIELD

The present invention relates to a current meter device for rechargeable mobile devices.

### BACKGROUND ART

As is known, most portable devices equipped with a rechargeable lithium cell-type battery recharge via USB.

USB charging uses a network adapter with a 5V USB output. The device being charged is usually charged via a male to male USB cable.

Some portable devices equipped with a lithium battery keep this battery live as long as they are powered, even after they have reached full charge; others leave the battery disconnected from its end-of-charge voltage for as long as they are powered. Currently, there are devices on the market capable of monitoring the charge current and the battery charge state; however, not all are capable of disconnecting it at the end of charging.

Similar devices on the market appear to be USB cables with the addition of control electronics on the current flow.

Not all devices capable of monitoring and controlling the charge of the device to be charged are aimed at disconnecting the battery when fully charged.

Furthermore, many of these replace the original charging cable, thus not being universal (for example, in the case of two smartphones with a different USB input connector, two devices with different USB output connectors will be needed).

US2018/269701 A1 describes an energy-saving charger capable of automatically powering off that includes a bridge rectifier circuit, a switch control circuit, a high-frequency transformer, and a low-voltage output circuit that are sequentially connected.

US 2009/294150 A1 describes a cable assembly for use with any power cable for an electrical device, the cable assembly including a remotely locatable switch for connecting or disconnecting the electrical device from power draw.

US2019/140464 A1 describes a device and method for saving power and electricity in a charging device including external power supplies and battery chargers having a primary circuit and a secondary circuit.

US 2013/200841 A1 describes a portable power supply adapted to be connected to an external power source and to an electronic device comprising a main module comprising a battery, a satellite module comprising an input port, and output port, and an interface panel, and a tether cable, and a controller.

It is an object of the present invention to solve the above problems of the prior art by providing a current meter device which is cable-free and thus structurally more robust with respect to the background art.

It is another object of the present invention to provide a device which is compact, easy to use and manufacture and at the same time effective in limiting the wear of the rechargeable battery of a device to be charged.

### DISCLOSURE OF THE INVENTION

The foregoing and other objects and advantages of the invention, as will result from the following description, are achieved with a current meter device and with a method for limiting the wear of a rechargeable battery of a device to be charged according to the independent claims. Preferred embodiments and non-trivial variants of the present invention form the object of the dependent claims.

It is understood that all of the appended claims form an integral part of the present disclosure.

It will be immediately obvious that innumerable variations and modifications (for example related to shape, dimensions, arrangements and parts with equivalent functionality) can be made to what is disclosed without deviating from the field of protection of the invention as appears from the appended claims.

In particular, the invention provides a current meter device according to claim 1.

Furthermore, the invention provides a method according to claim 8.

The present invention will be better described by some embodiments, provided by way of non-limiting example, with reference to the accompanying drawings, in which:
- FIG. 1 shows a schematic diagram of the main components of the device according to an example;
- FIG. 2 shows a schematic depiction of the current meter device according to an example;
- FIG. 3 shows an electric schematic diagram of the meter device according to an example; and
- FIG. 4 shows an electric schematic diagram of the meter device according to another example.

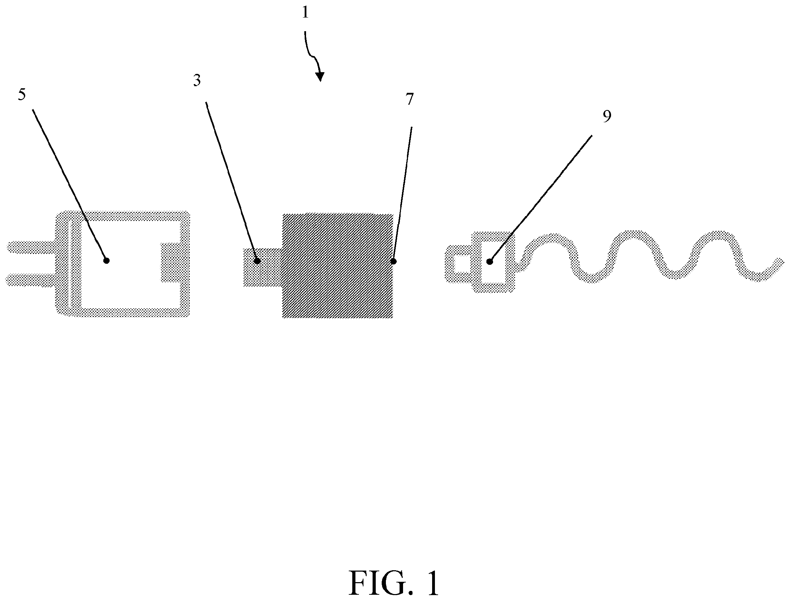

Referring to figure 1, it can be noted that the current meter device 1 comprises an input connector device 3, e.g., a male USB connector, and an output connector device 7, e.g., a female USB connector.

The input connector device 3 is designed to be operatively connected to at least one adapter device 5. Adapter device 5 means any device directly (or indirectly) connectable, for example, to the power supply mains to convert the alternating current drawn from the mains into a direct current suitable for charging a rechargeable battery. The adapter device 5 also serves to reduce the voltage to be supplied to the device to be charged. For example, the adapter device 5 can be represented by the battery charger, or rather by the component of the battery charger which connects to the mains, normally supplied with the purchase of a device equipped with a rechargeable battery.

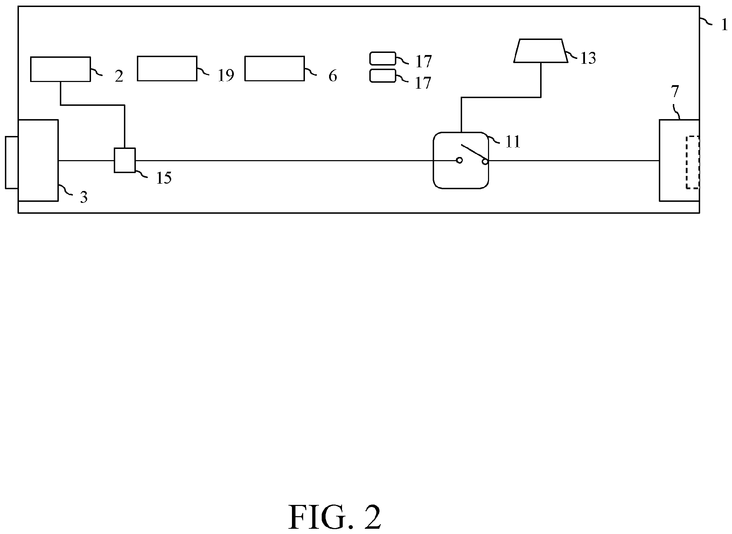

The output connector device 7 is designed to be operatively connected to at least one charging element 9, the connector device 7 being operatively connected to at least one device to be charged (not illustrated in the figure). For example, the device to be charged can be a cellular phone, a tablet, a laptop, etc., and the charging element 9 is understood as the connection cable which is usually used to connect the device to be charged to the charger (i.e., to the adapter device 5). The current meter device 1 further comprises at least one switch 11 (shown in figure 2) designed to operatively connect the charging element 9 to the adapter device 5, i.e., to create an electric connection between the input connector device 3 and the output connector device 7 when the charging phase of the device to be charged begins and to operatively disconnect the charging element 9 from the adapter device 5 when the charging phase has finished.

In other words, the meter device 1 is to be understood as an additional element to the standard charging instruments provided by the manufacturers of devices to be charged (e.g., smartphones, laptops, tablets,...). Instead of replacing the adapter or the power cord, the meter device 1 is inserted between these. In particular, one end of the meter device 1, i.e., the input connector device 3, connects to the power supply (or adapter device 5) via a male USB port of which it is equipped and the other end of the meter device 1, i.e., the output connector device 7, connects to the cable (charging element 9) via a female USB port of which it is equipped. Once inserted between these two components, and after connecting the adapter device 5 to the current, the switch 11 is activated to start the charging. By connecting via USB ports, the meter device 1 is removable and can be connected and disconnected between the two components mentioned above, namely the adapter device 5 and the charging element 9. It should be noted that in this manner the meter device 1 has full compatibility for example with the standard USB and can therefore be used for monitoring any device to be charged as long as for example it uses a USB connection for the charging function. For example, the connectors can directly be USB type A or USB type C or using optionally appropriate adapters.

The current meter device 1 has reduced size and weight so that it can be easily handled and transported. For example, the meter device 1 can have the shape of a cuboid having dimensions of about 3cm x 2.5cm x 5cm and weighing about 30 grams. Advantageously, the meter device 1 is compatible with rechargeable batteries of any power, in particular with a power of less than 65W, with a power of about 100W or with higher powers.

The meter device 1 is capable of reading the power required from the device to be charged (e.g., smartphone) to the adapter device 5 (e.g., battery charger) and disconnecting, thanks to a switch 11, the battery from the power supply (adapter device 5) when the energy needs of the device being charged have been met. In other words, it is like disconnecting the device directly from the charger. Unlike other charge controllers, the meter device 1 does not read the voltage or capacity of the battery but is able to analyse the current flow between the device being charged and the charger. This prevents the device to be charged from leaving the battery at the end-of-charge voltage while the device is connected to the charger. The prolonged maintenance of the end-of-charge voltage, typically 4.35V, on the battery causes a stress of the battery itself which reduces the useful life thereof. Then, disconnecting the device to be charged when the charge is complete, the battery voltage will drop thanks to the absorption of the device, preserving the life of the battery over time.

The meter device 1 does not comprise an internal power supply and is powered by the adapter device 5. The switch 11 can disconnect the power supplied by the adapter device 5 via the output connector device 7, interrupting the current flowing to the charging element 9.

As already mentioned, all portable devices equipped with a lithium battery usually keep the rechargeable battery at the end-of-charge voltage after reaching full charge. The technical problem addressed here concerns the charging of batteries, for example lithium ion, present in portable devices (computers, mobile phones, tablets, etc.) if they are recharged via a USB connection.

Advantageously, the meter device 1 is configured to electrically disconnect, by means of physical interruption of the conductors or other means, the battery at the end of charging.

By monitoring the current, it is possible to evaluate when the battery is charged and thus when to disconnect it.

In particular, the meter device 1 is not a USB cable but has a male input connector device 3 and a female output connector device 7 and is interposed between an adapter device 5 and a charging element 9 of the device to be charged (not shown in the figure), thus being universal.

Furthermore, the meter device 1 reads the current flowing between the input connector device 3 and the output connector device 7, disconnecting the device to be charged when the current read falls below a certain threshold. This threshold is set to reach the full charge of the device being charged, preventing the battery of the latter from remaining connected to the voltage even when charging is complete (most devices, when charging is complete, maintain a voltage on the battery between 4.2V and 4.35V) .

Figure 2 shows a schematization of the meter device 2 in which some functional components are shown. With reference to this figure, the meter device 1 comprises a current reader 2 for reading the electric current flowing between the input connector device 3 and the output connector device 7.

According to an example, the meter device 1 comprises a resistor 15 positioned between the input connector device 3 and the output connector device 7. The current meter 1 is configured to measure the electric current flowing between the input connector device 3 and the output connector device 7 by reading the voltage drop induced on the resistor 15.

The meter device 1 is implemented in the following manner: it reads the current flowing between the input connector device 3 and the output connector device 7 and pilots the switch 11 adapted to disconnect the device being charged when the current read falls below a certain threshold. As mentioned, the current is measured by reading the voltage drop induced on the resistor 15 by the current flowing between the input connector device 3 and the output connector device 7.

Advantageously, when the meter device 1 is connected to the adapter device 5 (for example USB power supply mains) via the input connector device 3, the switch 11 is in the open position and the device to be charged, connected to the output connector device 7 via the charging element 9, is not charging. According to an example, to initiate charging, the meter device 1 comprises at least one pressure element 13 for activating the switch 11, operatively connecting the output connector device 7 to the input connector device 3 and then to the adapter device 5. In particular, to start charging the device (it is necessary to press the pressure element 13, preferably a button, which activates the switch 11 which connects the output connector 7 to the power supplied by the adapter device 5.

In a further embodiment, the meter device 1 can be of the "plug and play" type in which there is a backup switch 11 to activate the device 1 in case it does not turn on itself.

According to an example, the meter device 1 comprises at least one indicator element 17 for sending a first light signal when the meter device 1 is operatively connected to the adapter device 5 and for sending a second light signal when the meter device 1 is operatively disconnected from the adapter device 5. Figure 2 shows the presence of two indicator elements 17. These can preferably be LED lights to indicate the state of the device: charging (connected to the adapter device 5) or not charging (disconnected from the adapter device 5). Advantageously, the current threshold at which the meter device 1 deactivates the switch 11, and thus disconnects the device to be charged, is set to complete the charging of the device to be charged before disconnecting it. For this purpose, the meter device 1 comprises at least one element determining a voltage reference, in particular a resistive divider element 19. It is thereby possible to determine the current threshold at which the meter device 1 operatively disconnects the output device 7 from the input device 3 via the switch 11.

According to the invention, the meter device 1 comprises a timer system 6 to regulate the activation of the switch 11, in particular to delay or prevent the activation and/or deactivation of the switch 11.

It should be noted that the presence of a timer system 6 serves to solve some of the problems which can arise when the device to be charged is being charged. In particular, the timer system 6 addresses the problems explained in the following four points.
1. Many devices, such as some smartphones, do not instantly absorb the charging current when they are connected to charge, but take a few seconds. The use of the timer system 6 allows the output to be left powered for a certain time after the button 13 has been pressed, regardless of the current read. After this time, it is assumed that the device is absorbing the charging current and the meter device 1 can read the current and activate the feedback with the threshold.
2. Some devices, such as some smartphones, can interrupt the current flow from the charger (adapter device 5) during charging for a variety of reasons. Also in this case, the timer system 6 can serve to disconnect the charging only after a period of time which is presumably longer than the time for which the device being charged has interrupted the current flow.
3. Some devices, such as some smartphones, when switched off and with the battery charged, still absorb current pulses. These current pulses, if not managed correctly, can deceive the reading of the current by reading a value above the threshold, reactivating the timer as described in the previous point (point 2), with the consequence that the device being charged is never disconnected from the charger.
4. Some devices, such as some smartphones, if they are charging when turned on with the battery fully charged and in standby, occasionally absorb current peaks (in addition to a fixed current minimum below the threshold) to communicate with the repeater or for other functions. These absorption peaks are longer than the pulses described in the previous point (point 3) but are much more distant in time (sometimes every few minutes) and still have an effect equal to the pulses described in point 3, deceiving the current reading and restarting the timer described in point 2.

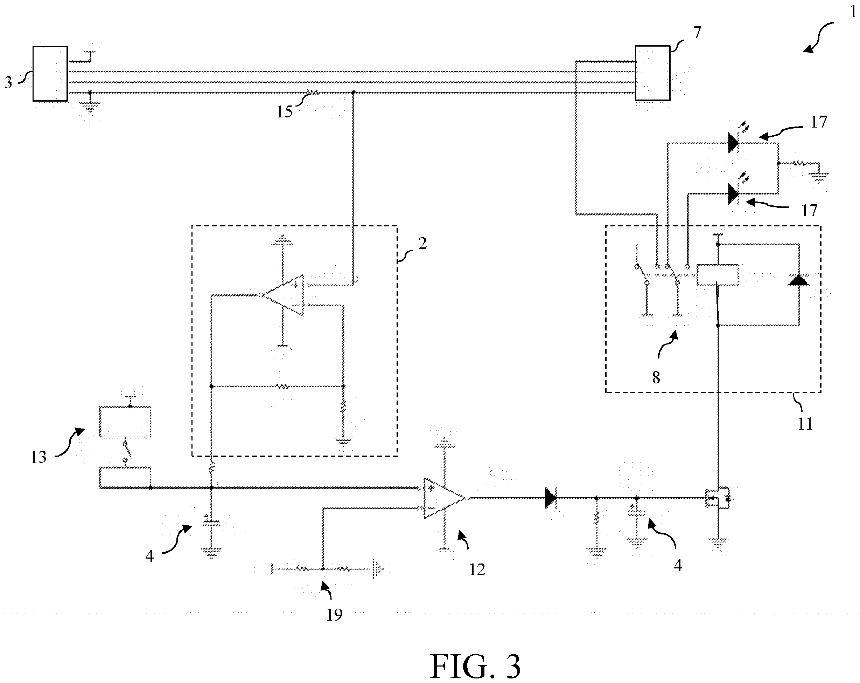

For example, the timer system 6 can comprise two analog timers consisting of two capacitors 4 (shown in figure 3). Taking advantage of the discharge time constant of the two capacitors 4, the two analog timers are implemented to allow the switch 11 to remain active for some minutes from the activation of the pressure element 13 and to delay the turning off of the switch 11 at the end of charging.

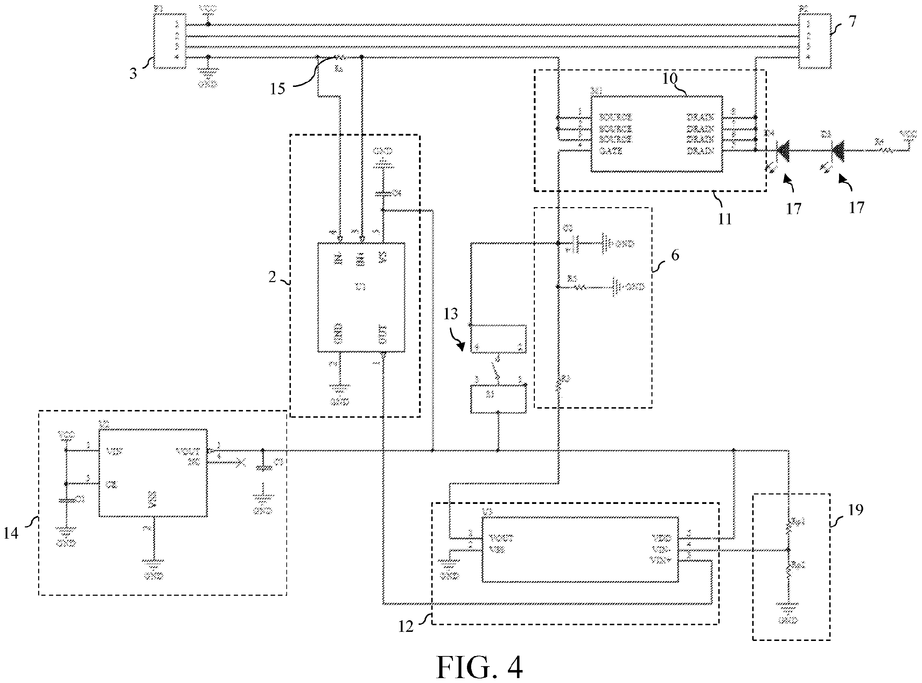

According to another example, the timer system 6 can consist solely of a capacitor C2 and a resistive network R3, R5, in particular a first resistor R3 and a second resistor R5 (shown in figure 4).

According to a further example, the switch 11 can comprise a relay device 8.

An example application of relay 8 as a switch 11 is shown in figure 3. As already highlighted, the meter device 1 works so as to read the current flowing between the input connector 3 (for example USB) and the output connector 7 (for example USB), disconnecting the device being charged when the current read falls below a certain threshold. This threshold is chosen to set the final battery charge level of the device, preventing the device from remaining connected to the power supply (i.e., to the adapter device 5) even at full charge.

By means of an electronic circuit which represents the current reader 2, the meter device 1 reads the current flowing between the input connector 3 and the output connector 7 across the resistor 15 and pilots the relay 8 adapted to disconnect the device being charged when the current read falls below a certain threshold. The current is read/estimated by reading the voltage drop induced on the resistor 15 by the current flowing between the input connector 3 and the output connector 7. When the meter device 1 is connected to the adapter device 5 via the input connector 3, the relay 8 is in the open position and the device to be charged, connected to the output connector 7 via the charging element 9, is not charging, being disconnected from the adapter device 5. To start charging, it is necessary to press the button 13 which activates the relay 8, which connects the device to be charged to the adapter device 5, placing it in charging mode. The two indicator lights 17 will indicate, for example with different colours, the state of the device: charging (connected to the adapter device 5) or not charging (disconnected from the adapter device 5). The current threshold at which the meter device 1 deactivates the relay 8, and thus disconnects the device to be charged, is determined by the charge percentage of the rechargeable battery at which the charging is to be stopped. If the battery is to be disconnected when the device is fully charged, the threshold will be set to a slightly higher current than the current absorbed by the device while the battery is charged. The threshold can be set by the resistive divider 19 which can be fixed (fixed threshold) or variable (adjustable threshold). For example, a trimmer can be used as a resistive divider 19 to set the threshold. Taking advantage of the discharge time constant of the two capacitors 4, it is possible to keep the relay 8 active for a few minutes from the activation of the pressure element 13 and to delay the switching off of the relay 8 at the end of charging.

Alternatively or additionally, the switch 11 can comprise a MOSFET 10. The use of an electronic switch such as a MOSFET (10) is more economical, with lower consumption and dimensions. However, unlike the use of the relay device 8, it does not physically disconnect the electrical conductors and is less resistant to electrostatic discharge and overvoltage.

An example application of MOSFET 10 as a switch 11 is shown in figure 4. It should be noted that below, for reasons of convenience, repeating the explanation of the components of this figure having the same reference number as those in figure 3 will be avoided where possible.

The current reader 2 is a voltage amplifier which amplifies the voltage drop on the resistor Rs 15. The amplified voltage value (which is linearly correlated with the current) is compared by the comparator 12 with a voltage value which corresponds to the desired current threshold (the voltage value is determined by a voltage divider 19 which uses the voltage stabilized by the regulator 14, for example at 4.4V. The output of the comparator 12 pilots the gate of the MOSFET 10 after being timed and filtered by the timer system 6. In this example, the timer system 6 consists of the network made up of the two resistors R3, R5 and the capacitor C2.

It should be noted that the timer system 6 consisting only of the three elements mentioned above (R3, R5 and C2) is capable of solving all four of the problems mentioned above in points 1-4, as explained below.

With regard to the problem of point 1, the button 13 is connected between the positive voltage and the capacitor C2 which in turn is connected to the gate of the MOSFET 10. When the button 13 is pressed, it charges C2 (almost instantly) which activates the MOSFET 10 which powers the device being charged. The capacitor C2 is then slowly discharged (about 3 minutes) through R5 and R3, giving the device time to activate the charging and absorb the current. Thereby, the comparator 12 brings the output thereof to the high voltage value by recharging the capacitor which will continue to keep the MOSFET 10 active.

If the current absorbed by the device to be charged drops below the threshold before the end of charging (and for no more than 3 minutes with reference to figure 4) the capacitor C2 will keep the gate of the MOSFET 10 active while waiting for the device being charged to resume absorbing current. Thereby, the problem described in point 2 is solved.

If, on the other hand, the device being charged, having reached the end of charging, absorbs current pulses while switched off (problem in point 3) or absorption peaks while switched on (problem in point 4), the resistive network R3 and R5 prevents the capacitor C2 from recharging quickly (but with the characteristic time constant of the RC circuit) and as long as the integral over time of the current peaks which charge C2 through R3 remains lower than the discharge constant of C2 through R3 and R5 during the absence of the pulses and only through R5 during the pulses (as in this case R3 charges the capacitor), the capacitor C2 will discharge over time, deactivating the MOSFET 10 and thus disconnecting the device being charged.

Thereby, with two resistors and one capacitor, all four of the timing problems listed above have been solved. It is clear that such a timer system 6 greatly reduces the complexity of the meter device 1 without however sacrificing the effectiveness of the operation. It should be noted that the problems mentioned above in points 1-4 could similarly be solved by using a microcontroller and an *ad hoc* algorithm, greatly increasing the complexity of the solution however.

It should be noted that figure 3 shows a meter device 1 in which the switch 11 comprises a relay device 8 and the timer system 6 consists of two capacitors 4 (two timers) while figure 4 shows a meter device 1 in which the switch 11 comprises a MOSFET 10 and the timer system 6 consists of a single timer made up of a network of a capacitor C2 and two resistors R3, R5. It should be noted, however, that these configurations are not limiting and can be combined with each other. For example, the meter device 1 can have a switch 11 comprising a relay 8 as in figure 3 and a timer system 6 as in figure 4. Similarly, the meter device 1 can have a switch 11 comprising a MOSFET 10 as in figure 4 and a timer system 6 as in figure 3. According to an example, in the method for limiting the wear of a rechargeable battery described herein, the switch 11 of the meter device 1 is activated by actuating a pressure element 13 and the method further comprises keeping the switch 11 activated for a predetermined time, in particular for a time between 1 and 5 minutes, from the actuation of the pressure element 13 regardless of the value of the current read. Alternatively or in addition, the method comprises restoring the charging state of the device to be charged if the power supply of the meter device 1 is stopped and restored, storing the state of the switch 11 for a predetermined time, in particular for a time between 1 and 5 minutes.

According to the invention, the method comprises maintaining the output of the timer 6 as if the current read was below the current threshold if one or more current pulses, absorbed by the device to be charged, exceed the current threshold, when said device to be charged has reached the end of charging. In other words, the output of the timer 6 is maintained at a value below the current threshold by a current pulse filtering process. Thereby, it avoids restarting the timer system 6 even though the device to be charged has reached the end of charging and absorbs one or more current pulses which, read by the meter device 1, are higher than the current threshold (and therefore would restart the timer 6). This is to avoid an incorrect interpretation of the measured current following the absorption of current pulses as highlighted in points 3 and 4 above, and therefore correctly disconnecting the device at the end of charging.

In an example, the method comprises maintaining the charging state of the device despite the measured current being less than the threshold, as long as the time interval for which it is less than the threshold is less than the value of the timer 6. When the current absorbed by the device being charged is restored, the timer system 6 present in the current meter device 1 is restarted. As mentioned above, the value of the threshold is always the same and is determined by the resistive divider 19. The pre-set time value is that determined by the timer system 6, for example between 1 and 5 minutes, advantageously three minutes.

In a further example, the method comprises at least one of the following steps:
powering the device to be charged directly through the mains without simultaneously powering the rechargeable battery connected to the device to be charged;
varying the value of the charging of the rechargeable battery connected to the device to be charged between a maximum charge value and a minimum discharge value in a cyclical and automatic manner;
setting a percentage current threshold at which to disconnect the device to be charged even if the device to be charged is turned off; and
measuring the value of the temperature of the rechargeable battery connected to the device to be charged and adapting the value of the charging current as a function of said temperature value.

In a further example, the method comprises disabling the ultra-fast charging function of the device to be charged during the charging step.

As already highlighted, the meter device 1 serves to avoid early wear of the rechargeable battery. For this purpose, in addition to automatically disconnecting the device being charged when the battery is charged, the meter device 1 is also configured to disable the ultra-fast charging, typical of some devices to be charged, such as some mobile phones. The ultra-fast charging is turned off because it causes more battery wear than slow charging. In particular, the devices to be charged, for example smartphones which use the standard USB 2.0 to recharge with powers beyond those allowed by the USB standard, use an additional pin of the standard 3.0 to be able to verify that the charger and cable are original and that they can therefore support powers much higher than those allowed by the normal cables (for example the Realme 7 Pro works at 10V 6.5A). The meter device 1 uses only the four pins of the standard USB 2.0 without connecting additional pins of the standard 3.0. Thereby, the device to be charged, even with the original adapter and cable, will not be able to read the "proprietary" pin for ultra-fast charging and consequently will not activate it.

In a further embodiment, the current meter device 1 can comprise a microcontroller for digitally managing both the basic function of reading the current and activating/deactivating the switch 11 as described above, and communication with the device to be charged for more advanced functions. For example, an application program (App) on the device to be charged (e.g., on the smartphone) can allow the display of information and the management of all the options provided by the meter device 1 and the charging profiles of the various devices to be charged.

According to this embodiment, in addition to monitoring the current absorbed by the charging device, different charging protocols can be implemented to allow the user to set the current being absorbed by the device. For example, depending on the voltages on the feet D+ and D- of the USB 2.0 and the Power Delivery of the USB type C, it will be possible to set different charging speeds which result in a different current and voltage supplied by the power supply, as long as it supports them (adapter device 5). The communication with the device to be charged can occur by means of the Bluetooth protocol which allows to monitor both the charge and the battery parameters (voltage, temperature, absorbed current) in real time, and to set the charging parameters on the meter device 1 to then use it on devices without Bluetooth or with the smartphone turned off.

When the device to be charged is turned on and can communicate the charge state thereof in real time, it will be possible to set a maximum charge threshold at which the device being charged will be disconnected from the meter device 1 and thus from the adapter device 5 (charger). For example, by setting a 90% threshold, the device which reaches 90% battery charge will be disconnected from the charger. It is also possible to set a minimum charge threshold below which the device being charged will be reconnected to the charger (adapter device 5). For example, by setting a minimum threshold of 50% and a maximum of 60% it is possible to charge the device when the battery charge percentage reaches 50% and disconnect it from charging when the charge reaches 60%, thereby the battery will carry out charging and discharging cycles in an area away from harmful voltages (end of charge voltage and discharged battery voltage).

It should be noted that the life of a battery is measured in charge cycles. The recharging cycle here refers to a discharge and a recharge of the entire capacity of the battery, not necessarily carried out in a single time. For example, in one day only half the charge of a notebook can be used, and then it is recharged completely. If the same thing is done the next day, only one recharge cycle is calculated, not two. Thereby, it may take several days for a cycle to complete. Charging a laptop up to 90% charge and only recharging it when the charge drops to 60%, the battery will cycle charging and discharging in an area away from harmful voltages. On the other hand, being able to avoid charging the battery while using the device, for example using only the mains, the battery would not lose valuable charging cycles and consequently it would increase the life thereof.

In addition, it is possible to use self-learning algorithms by which the meter device 1 learns to what current flow a given charge percentage corresponds. In doing so, a percentage threshold can be set even if the charging device is switched off (the smartphone and the meter device 1 cannot communicate directly). After some learning recharges, in which the meter device 1 will create a correlation between the current flow and the charge percentage of a particular device, the meter device 1 will be able to understand, monitoring the charging current flow, the charge percentage of the battery and disconnect it accordingly to the desired percentage (clearly this feature can be exploited only in the step of saturation of the constant voltage current, therefore between 85% and 100% of the charge; in the charging step at a constant current, just as the current is constant, it is not possible to determine the charge percentage by reading the current flow).

For devices which do not have a Bluetooth connection, and therefore cannot communicate with the meter device 1, it is possible to manually set a threshold (always in the saturation step of the current) lower than 100% of the charge by specifying, for example through the application program, the moment in which to interrupt the current flow. For example, if a drone's battery is charged via USB and the charge is to be interrupted at 95%, as soon as that percentage is reached it will be set by the application on the smartphone that it is time to stop charging. The meter device 1 will store the information and the next time, by recalling the charging profile of the drone battery, it will stop charging at the desired charge percentage.

A further function is represented by the Timer mode. Having a determined time to charge the mobile phone to a certain percentage, the meter device 1 can calculate and provide the best charging protocol to stress the battery as little as possible. For example, by setting through the application that two hours are available for charging the smartphone and it is to be charged up to 90% (and the current charge is 40%), the meter device 1 can calculate the current needed to provide the required charge (based on the capacity of the battery, the time it must take and the initial and final charge percentage) in the required time and can set the best charging protocol.

Furthermore, it is also possible to set a time at which the device to be charged (e.g., the smartphone) must be charged at a set percentage. For example, a smartphone can be set to be 100% charged at 8 in the morning. The meter device 1 can calculate, based on the time available, the minimum current in order to be able to recharge it up to the desired percentage and the desired time. This feature, unlike the algorithm on some smartphones, which allows to learn the user's habits and then try to charge the battery in the best manner, does not allow the user to choose the time from time to time (very convenient especially when the user does not have fixed hours at which they go to sleep or wake up). Finally, by taking the battery temperature data, for example from the cell phone, the meter device according to this embodiment can decrease the charging current when the battery exceeds a "critical" temperature (pre-set or user modifiable), with the aim of stressing the battery as little as possible during the charging step and prolonging the life thereof as much as possible.

The current meter device 1 described above can be applied in various technological sectors where devices equipped with lithium-ion batteries are present.

In addition to use in rechargeable computing devices such as smartphones, tablets, the current meter device 1 can advantageously be used for charging particular household appliances, such as cordless vacuum cleaners, robot vacuum cleaners, or other home automation devices, and for charging electric vehicles such as electric scooters, electric bicycles and electric scooters.

Some preferred embodiments of the invention have been described, but of course they are susceptible to further modification and variation within the same inventive concept. In particular, numerous variations and modifications, functionally equivalent to the previous ones, which fall within the scope of the invention as defined in the attached claims in which any reference marks placed in brackets cannot be interpreted as limiting the claims themselves, will be immediately apparent to those skilled in the art. Furthermore, the word "comprising" does not exclude the presence of other elements and/or steps different from those listed in the claims. The article "a" or "an" preceding an element does not exclude the presence of a plurality of such elements. The mere fact that certain features are recited in different dependent claims does not indicate that a combination of these features cannot be advantageously used.

## Claims

1. Current meter device (1) comprising:
an input connector device (3) for operatively connecting said current meter device (1) removably to at least one adapter device (5), said adapter device (5) being connectable to the power supply mains;
an output connector device (7) for operatively connecting said current meter device (1) removably to at least one charging element (9), said charging element (9) being operatively connectable to at least one device to be charged having at least one rechargeable battery;
a current reader (2) for reading the electric current flowing between the input connector device (3) and the output connector device (7); and
at least one switch (11) for operatively connecting the device to be charged by the charging element (9) to said current meter device (1) and then to the adapter (5) when the charging phase of said element to be charged begins, and for disconnecting the device to be charged from said current meter device (1) when the electrical current read by the current reader (2) is lower than a current threshold and the charging phase has finished
**characterized in that**
the current meter device (1) further comprises a timer system (6) to adjust the activation of the switch (11), in particular to delay or prevent the activation and/or deactivation of the switch (11), wherein the timer system (6) consists only of a capacitor (C2) and a resistive network (R3, R5), in particular a first resistor (R3) and a second resistor (R5) and wherein the output of said timer system (6) is maintained as if the current read is below the current threshold if one or more current pulses absorbed by the device to be charged exceed said current threshold when said device to be charged has reached the end of charging.

2. Current meter device (1) according to claim 1, comprising at least one pressure element (13) for activating the switch (11), operatively connecting the output connector device (7) to the input connector device (3) and then to the adapter device (5).

3. Current meter device (1) according to claims 1 or 2, comprising a resistor Rs (15) positioned between the input connector device (3) and the output connector device (7), wherein the current meter is configured to measure the electric current flowing between the input connector device (3) and the output connector device (7) by reading the voltage drop induced on said resistor Rs (15).

4. Current meter device (1) according to any one of the preceding claims, comprising at least one indicator element (17) for sending a first light signal when said current meter device (1) is operatively connected to the adapter device (5) and for sending a second light signal when said current meter device (1) is operatively disconnected from the adapter device (5).

5. Current meter device (1) according to any one of the preceding claims, comprising at least one voltage reference determining element, in particular a resistive divider element (19), for determining the current threshold at which the current meter device (1) operatively disconnects the output device (7) from the input device (3) via the switch (11).

6. Current meter device (1) according to one of the preceding claims, wherein the switch (11) comprises
a. a relay device (8); and/or
b. a MOSFET (10).

7. Current meter device (1) according to one of the preceding claims, further comprising a microcontroller.

8. Method for limiting the wear of at least one rechargeable battery connected to a device to be charged comprising:
removably connecting a current meter device (1) between an adapter device (5) and a charging element (9), wherein the current meter device (1) comprises an input connector (3) connectable to the adapter device (5) and an output connector (7) connectable to the charging element (9) and the adapter device (5) is connectable to the power supply mains and the charging element (9) is operatively connectable to the device to be charged,
reading the electric current flowing between the input connector device (3) and the output connector device (7);
activating a switch (11) of the current meter device (1) to operatively connect the device to be charged via the charging element (9) to said current meter device (1) and then to the adapter (5) when the charging phase of said element to be charged begins; and
deactivating said switch (11) to disconnect the device to be charged from said current meter device (1) when the electric current read by the current reader (2) is lower than said current threshold and the charging phase is finished,
**characterized by**
maintaining the output of a timer system (6) present in the current meter device (1) as if the current read is below the current threshold if one or more current pulses absorbed by the device to be charged exceed said current threshold when said device to be charged has reached the end of charging.

9. Method according to claim 8, wherein activating the switch (11) of the current meter device (1) occurs by actuating a pressure element (13) and the method further comprises:
a. keeping the switch (11) activated for a predetermined time, in particular for a time between 1 and 5 minutes, from the actuation of the pressure element (13) regardless of the value of the current read; and/or
b. restoring the charging state of the device to be charged if the power supply of the current meter device (1) is stopped and restored, storing the state of the switch (11) for a predetermined time, in particular for a time between 1 and 5 minutes.

10. Method according to one of claims 8 to 9, further comprising restarting a timer system (6) present in the current meter device (1) as a function of the electric current read when the current absorbed by the device being charged is restored, whenever said electric current read exceeds a predefined threshold value for a predetermined time interval.

11. Method according to one of claims 8 to 10, further comprising at least one of the following steps:
powering the device to be charged directly through the mains without simultaneously powering the rechargeable battery connected to the device to be charged;
varying the value of the charging of the rechargeable battery connected to the device to be charged between a maximum charge value and a minimum discharge value in a cyclical and automatic manner;
setting a percentage current threshold at which to disconnect the device to be charged even if the device to be charged is turned off;
measuring the value of the temperature of the rechargeable battery connected to the device to be charged and adapting the value of the charging current as a function of said temperature value; and
disabling an ultra-fast charging function of the device to be charged during the charging step.

## Patentansprüche

1. Strommessvorrichtung (1), umfassend:
eine Eingangsverbindervorrichtung (3) zum wirksamen Verbinden der Strommessvorrichtung (1) lösbar mit mindestens einer Adaptervorrichtung (5), wobei die Adaptervorrichtung (5) mit dem Stromversorgungsnetz verbindbar ist;
eine Ausgangsverbindervorrichtung (7) zum wirksamen Verbinden der Strommessvorrichtung (1) lösbar mit mindestens einem Ladeelement (9), wobei das Ladeelement (9) wirksam mit mindestens einer zu ladenden Vorrichtung verbindbar ist, die mindestens eine wiederaufladbare Batterie aufweist;
einen Stromabtaster (2) zum Abtasten des elektrischen Stroms, der zwischen der Eingangsverbindervorrichtung (3) und der Ausgangsverbindervorrichtung (7) fließt; und
mindestens einen Schalter (11) zum wirksamen Verbinden der durch das Ladeelement (9) zu ladenden Vorrichtung mit der Strommessvorrichtung (1) und anschließend mit dem Adapter (5), wenn die Ladephase des zu ladenden Elements beginnt, und zum Trennen der zu ladenden Vorrichtung von der Strommessvorrichtung (1), wenn der elektrische Strom, der durch den Stromabtaster (2) abgetastet wird, geringer als eine Stromschwelle ist und die Ladephase abgeschlossen ist
**dadurch gekennzeichnet, dass**
die Strommessvorrichtung (1) ferner ein Zeitgebersystem (6) zur Anpassung der Aktivierung des Schalters (11), insbesondere zur Verzögerung oder Verhinderung der Aktivierung und/oder Deaktivierung des Schalters (11), umfasst, wobei das Zeitgebersystem (6) lediglich aus einem Kondensator (C2) und einem Widerstandsnetzwerk (R3, R5), insbesondere einem ersten Widerstand (R3) und einem zweiten Widerstand (R5), besteht, und wobei die Ausgabe des Zeitgebersystems (6) so aufrechterhalten wird, als würde der abgetastete Strom unterhalb der Stromschwelle liegen, wenn ein oder mehrere Stromimpulse, die von der zu ladenden Vorrichtung aufgenommen werden, die Stromschwelle überschreiten, wenn die zu ladende Vorrichtung das Ende der Aufladung erreicht hat.

2. Strommessvorrichtung (1) nach Anspruch 1, die mindestens ein Druckelement (13) zum Aktivieren des Schalters (11) umfasst, wodurch die Ausgangsverbindervorrichtung (7) wirksam mit der Eingangsverbindervorrichtung (3) und anschließend mit der Adaptervorrichtung (5) verbunden wird.

3. Strommessvorrichtung (1) nach Anspruch 1 oder 2, die einen Widerstand Rs (15) umfasst, der zwischen der Eingangsverbindervorrichtung (3) und der Ausgangsverbindervorrichtung (7) angeordnet ist, wobei der Strommesser konfiguriert ist, den elektrischen Strom, der zwischen der Eingangsverbindervorrichtung (3) und der Ausgangsverbindervorrichtung (7) fließt, durch Abtasten des an dem Widerstand Rs (15) induzierten Spannungsabfalls zu messen.

4. Strommessvorrichtung (1) nach einem der vorhergehenden Ansprüche, die mindestens ein Indikatorelement (17) zum Senden eines ersten Lichtsignals, wenn die Strommessvorrichtung (1) wirksam mit der Adaptervorrichtung (5) verbunden ist, und zum Senden eines zweiten Lichtsignals, wenn die Strommessvorrichtung (1) wirksam von der Adaptervorrichtung (5) getrennt ist, umfasst.

5. Strommessvorrichtung (1) nach einem der vorhergehenden Ansprüche, die mindestens ein Spannungsreferenz-Bestimmungselement, insbesondere ein Widerstandsteilerelement (19), zum Bestimmen der Stromschwelle, bei der die Strommessvorrichtung (1) die Ausgangsvorrichtung (7) über den Schalter (11) wirksam von der Eingangsvorrichtung (3) trennt, umfasst.

6. Strommessvorrichtung (1) nach einem der vorhergehenden Ansprüche, wobei der Schalter (11) Folgendes umfasst
a. eine Relaisvorrichtung (8); und/oder
b. einen MOSFET (10).

7. Strommessvorrichtung (1) nach einem der vorhergehenden Ansprüche, die ferner einen Mikrocontroller umfasst.

8. Verfahren zum Beschränken der Beanspruchung mindestens einer wiederaufladbaren Batterie, die mit einer zu ladenden Vorrichtung verbunden ist, umfassend:
lösbares Verbinden einer Strommessvorrichtung (1) zwischen einer Adaptervorrichtung (5) und einem Ladeelement (9), wobei die Strommessvorrichtung (1) einen Eingangsverbinder (3), der mit der Adaptervorrichtung (5) verbindbar ist, und einen Ausgangsverbinder (7), der mit dem Ladeelement (9) verbindbar ist, umfasst und die Adaptervorrichtung (5) mit dem Stromversorgungsnetz verbindbar ist und das Ladeelement (9) wirksam mit der zu ladenden Vorrichtung verbindbar ist,
Abtasten des elektrischen Stroms, der zwischen der Eingangsverbindervorrichtung (3) und der Ausgangsverbindervorrichtung (7) fließt;
Aktivieren eines Schalters (11) der Strommessvorrichtung (1), um die zu ladende Vorrichtung über das Ladeelement (9) wirksam mit der Strommessvorrichtung (1) und anschließend mit dem Adapter (5) zu verbinden, wenn die Ladephase des zu ladenden Elements beginnt; und
Deaktivieren des Schalters (11), um die zu ladende Vorrichtung von der Strommessvorrichtung (1) zu trennen, wenn der elektrische Strom, der durch den Stromabtaster (2) abgetastet wird, geringer als die Stromschwelle ist und die Ladephase abgeschlossen ist,
**gekennzeichnet durch**
Aufrechterhalten der Ausgabe eines Zeitgebersystems (6), das in der Strommessvorrichtung (1) vorhanden ist, so, als würde der abgetastete Strom unter der Stromschwelle liegen, wenn ein oder mehrere Stromimpulse, die von der zu ladenden Vorrichtung aufgenommen werden, die Stromschwelle überschreiten, wenn die zu ladende Vorrichtung das Ende der Aufladung erreicht hat.

9. Verfahren nach Anspruch 8, wobei das Aktivieren des Schalters (11) der Strommessvorrichtung (1) durch Betätigen eines Druckelements (13) erfolgt und das Verfahren ferner Folgendes umfasst:
a. Aktiviertlassen des Schalters (11) für eine vorbestimmte Zeit, insbesondere für eine Zeit zwischen 1 und 5 Minuten, ab der Betätigung des Druckelements (13) unabhängig von dem Wert des abgetasteten Stroms; und/oder
b. Wiederherstellen des Ladezustands der zu ladenden Vorrichtung, wenn die Stromversorgung der Strommessvorrichtung (1) unterbrochen und wiederhergestellt wird, wobei der Zustand des Schalters (11) für eine vorbestimmte Zeit, insbesondere für eine Zeit zwischen 1 und 5 Minuten, gespeichert wird.

10. Verfahren nach einem der Ansprüche 8 bis 9, das ferner ein Neustarten eines Zeitgebersystems (6), das in der Strommessvorrichtung (1) vorhanden ist, in Abhängigkeit von dem abgetasteten elektrischen Strom, wenn der von der Vorrichtung, die geladen wird, aufgenommene Strom wiederhergestellt ist, umfasst, immer dann, wenn der abgetastete elektrische Strom einen vorgegebenen Schwellenwert für ein vorbestimmtes Zeitintervall überschreitet.

11. Verfahren nach einem der Ansprüche 8 bis 10, das ferner mindestens einen der folgenden Schritte umfasst:
Versorgen der zu ladenden Vorrichtung direkt über das Netz ohne gleichzeitiges Versorgen der wiederaufladbaren Batterie, die mit der zu ladenden Vorrichtung verbunden ist;
Variieren des Werts der Aufladung der wiederaufladbaren Batterie, die mit der zu ladenden Vorrichtung verbunden ist, zwischen einem maximalen Ladewert und einem minimalen Entladewert in zyklischer und automatischer Weise;
Einstellen einer prozentualen Stromschwelle, bei der die zu ladende Vorrichtung getrennt werden soll, selbst dann, wenn die zu ladende Vorrichtung ausgeschaltet ist;
Messen des Werts der Temperatur der wiederaufladbaren Batterie, die mit der zu ladenden Vorrichtung verbunden ist, und Anpassen des Werts des Ladestroms in Abhängigkeit von dem Temperaturwert; und
Deaktivieren einer Funktion für ultraschnelles Laden der Vorrichtung, die während des Ladeschritts geladen werden soll.

## Revendications

1. Dispositif de mesure de courant (1) comprenant :
un dispositif connecteur d'entrée (3) pour relier fonctionnellement ledit dispositif de mesure de courant (1), de manière amovible, à au moins un dispositif adaptateur (5), ledit dispositif adaptateur (5) pouvant être relié au réseau de distribution de courant ;
un dispositif connecteur de sortie (7) pour relier fonctionnellement ledit dispositif de mesure de courant (1), de manière amovible, à au moins un élément de charge (9), ledit élément de charge (9) pouvant être relié fonctionnellement à au moins un dispositif à charger comportant au moins une batterie rechargeable ;
un lecteur de courant (2) pour relever le courant électrique s'écoulant entre le dispositif connecteur d'entrée (3) et le dispositif connecteur de sortie (7) ; et
au moins un commutateur (11) pour relier fonctionnellement le dispositif à charger par l'élément de charge (9) audit dispositif de mesure de courant (1) puis à l'adaptateur (5) lorsque la phase de charge dudit élément à charger commence, et pour débrancher le dispositif à charger dudit dispositif de mesure de courant (1) lorsque le courant électrique relevé par le lecteur de courant (2) est inférieur à un seuil de courant et la phase de charge est terminée,
**caractérisé en ce que**
le dispositif de mesure de courant (1) comprend en outre un système de minuterie (6) pour ajuster l'activation du commutateur (11), en particulier pour retarder ou interdire l'activation et/ou la désactivation du commutateur (11), dans lequel le système de minuterie (6) ne se compose que d'un condensateur (C2) et d'un réseau résistif (R3, R5), en particulier une première résistance (R3) et une deuxième résistance (R5), et dans lequel la sortie dudit système de minuterie (6) est maintenue comme si le relevé de courant était inférieur au seuil de courant si une ou plusieurs impulsions de courant absorbées par le dispositif à charger dépassent ledit seuil de courant lorsque ledit dispositif à charger a atteint la fin de charge.

2. Dispositif de mesure de courant (1) selon la revendication 1, comprenant au moins un élément de pression (13) pour activer le commutateur (11), reliant fonctionnellement le dispositif connecteur de sortie (7) au dispositif connecteur d'entrée (3) puis au dispositif adaptateur (5).

3. Dispositif de mesure de courant (1) selon la revendication 1 ou 2, comprenant une résistance Rs (15) positionnée entre le dispositif connecteur d'entrée (3) et le dispositif connecteur de sortie (7), dans lequel le dispositif de mesure de courant est configuré pour mesurer le courant électrique s'écoulant entre le dispositif connecteur d'entrée (3) et le dispositif connecteur de sortie (7) par le relevé de la baisse de tension induite sur ladite résistance Rs (15).

4. Dispositif de mesure de courant (1) selon l'une quelconque des revendications précédentes, comprenant au moins un élément indicateur (17) pour envoyer un premier signal lumineux lorsque ledit dispositif de mesure de courant (1) est relié fonctionnellement au dispositif adaptateur (5) et pour envoyer un deuxième signal lumineux lorsque ledit dispositif de mesure de courant (1) est débranché fonctionnellement du dispositif adaptateur (5).

5. Dispositif de mesure de courant (1) selon l'une quelconque des revendications précédentes, comprenant au moins un élément de détermination de référence de tension, en particulier un élément diviseur résistif (19), pour déterminer le seuil de courant auquel le dispositif de mesure de courant (1) débranche fonctionnellement le dispositif de sortie (7) du dispositif d'entrée (3) via le commutateur (11).

6. Dispositif de mesure de courant (1) selon l'une quelconque des revendications précédentes, dans lequel le commutateur (11) comprend
a. un dispositif relais (8) ; et/ou
b. un MOSFET (10).

7. Dispositif de mesure de courant (1) selon l'une quelconque des revendications précédentes, comprenant en outre un microcontrôleur.

8. Procédé de limitation de l'usure d'au moins une batterie rechargeable reliée à un dispositif à charger comprenant :
le branchement, de manière amovible, d'un dispositif de mesure de courant (1) entre un dispositif adaptateur (5) et un élément de charge (9), dans lequel le dispositif de mesure de courant (1) comprend un dispositif connecteur d'entrée (3) pouvant être relié au dispositif adaptateur (5) et un dispositif connecteur de sortie (7) pouvant être relié à l'élément de charge (9) et le dispositif adaptateur (5) peut être relié au réseau de distribution de courant et l'élément de charge (9) peut être relié fonctionnellement au dispositif à charger,
le relevé du courant électrique s'écoulant entre le dispositif connecteur d'entrée (3) et le dispositif connecteur de sortie (7) ;
l'activation d'un commutateur (11) du dispositif de mesure de courant (1) pour relier fonctionnellement le dispositif à charger via l'élément de charge (9) audit dispositif de mesure de courant (1) puis à l'adaptateur (5) lorsque la phase de charge dudit élément à charger commence ; et
la désactivation dudit commutateur (11) pour débrancher le dispositif à charger dudit dispositif de mesure de courant (1) lorsque le courant électrique relevé par le lecteur de courant (2) est inférieur audit seuil de courant et la phase de charge est terminée,
**caractérisé par**
le maintien de la sortie d'un système de minuterie (6) présent dans le dispositif de mesure de courant (1) comme si le relevé de courant était inférieur au seuil de courant si une ou plusieurs impulsions de courant absorbées par le dispositif à charger dépassent ledit seuil de courant lorsque ledit dispositif à charger a atteint la fin de charge.

9. Procédé selon la revendication 8, dans lequel l'activation du commutateur (11) du dispositif de mesure de courant (1) survient par l'actionnement d'un élément de pression (13) et le procédé comprend en outre :
a. le maintien du commutateur (11) activé pendant un temps prédéterminé, en particulier pendant un temps entre 1 et 5 minutes, à partir de l'actionnement de l'élément de pression (13) indépendamment de la valeur du relevé de courant ; et/ou
b. le rétablissement de l'état de charge du dispositif à charger si l'alimentation électrique du dispositif de mesure de courant (1) est arrêtée et rétablie, le stockage de l'état du commutateur (11) pendant un temps prédéterminé, en particulier pendant un temps entre 1 et 5 minutes.

10. Procédé selon la revendication 8 ou 9, comprenant en outre le redémarrage d'un système de minuterie (6) présent dans le dispositif de mesure de courant (1) en fonction du relevé de courant électrique lorsque le courant absorbé par le dispositif en cours de charge est rétabli, chaque fois que ledit relevé de courant électrique dépasse une valeur de seuil prédéfinie pendant un intervalle de temps prédéterminé.

11. Procédé selon l'une des revendications 8 à 10, comprenant en outre au moins l'une des étapes suivantes :
l'alimentation du dispositif à charger directement par le réseau de distribution de courant sans alimenter simultanément la batterie rechargeable reliée au dispositif à charger ;
la variation de la valeur de la charge de la batterie rechargeable reliée au dispositif à charger entre une valeur de charge maximale et une valeur de décharge minimale d'une manière cyclique et automatique ;
la définition d'un seuil de courant en pourcentage auquel le dispositif à charger doit être débranché même si le dispositif à charger est hors tension ;
la mesure de la valeur de la température de la batterie rechargeable reliée au dispositif à charger et l'adaptation de la valeur du courant de charge en fonction de ladite valeur de température ; et
la désactivation d'une fonction de charge ultrarapide du dispositif à charger pendant l'étape de charge.
